Europäisches Patentamt

European Patent Office

Office européen des brevets

(19)

(11) Veröffentlichungsnummer : **0 100 950**
**B1**

(12)

# EUROPÄISCHE PATENTSCHRIFT

(45) Veröffentlichungstag der Patentschrift :
11.02.87

(21) Anmeldenummer : 83107248.3

(22) Anmeldetag : 23.07.83

(51) Int. Cl.⁴ : **G 01 R 1/06**

(54) **Tragbare Messvorrichtung.**

(30) Priorität : 10.08.82 DE 3229689

(43) Veröffentlichungstag der Anmeldung :
22.02.84 Patentblatt 84/08

(45) Bekanntmachung des Hinweises auf die Patenterteilung : 11.02.87 Patentblatt 87/07

(84) Benannte Vertragsstaaten :
AT BE CH DE FR GB IT LI NL SE

(56) Entgegenhaltungen :
CH-A- 384 355
DE-A- 2 836 679
DE-A- 2 843 221

(73) Patentinhaber : METRAWATT GMBH
Thomas-Mann-Strasse 16-20
D-8500 Nürnberg (DE)

(72) Erfinder : Hochreuther, Karl
Hersbruckerstrasse 98
D-8500 Nürnberg (DE)
Erfinder : Tragatschnig, Jörg
Weidenweg 3
A-5700 Zell am See (AT)

(74) Vertreter : Kempe, Wolfgang, Dr. et al
c/o Metrawatt GmbH Patentabteilung Postfach 3 51
D-6800 Mannheim 1 (DE)

EP 0 100 950 B1

Jouve, 18, rue St-Denis, 75001 Paris, France

**Beschreibung**

Die Erfindung betrifft tragbare Meßvorrichtungen der im Oberbegriff des Anspruchs 1 sowie der im Oberbegriff des Anspruchs 3 genannten Art.

Meßvorrichtungen mit einem Vielfachmeßgerät, zugehörigen Meßleitungen und daran befestigten Meßspitzen werden bei Prüfarbeiten häufig an Orten verwendet, an denen kein Arbeitstisch zur Verfügung steht. In solchen Fällen ist es von Vorteil, wenn das Meßgerät mit einem Traggurt ausgerüstet ist, mit dessen Hilfe es um den Hals gehängt werden kann. Auf diese Weise kann es dann leicht von einer Arbeitsstelle zur anderen getragen werden ohne das Gerät in der Hand halten zu müssen, und die Hände bleiben zum Ausführen der Meßarbeiten frei.

Aus der DE-A-28 36 679 ist ein klappbares Vielfachmeßgerät bekannt, das durch seine konstruktive Gestaltung besonders gut mit einem Traggurt um den Hals gehängt werden kann. Der Oberbegriff des Anspruchs 1 der Erfindung geht von dieser Veröffentlichung aus. Nachteilig bei dieser tragbaren Meßvorrichtung ist jedoch, daß die relativ langen Meßleitungen unmittelbar am Meßgerät angeschlossen sind und von diesem pendelnd herabhängen. Eine unkontrollierte Pendelbewegung der Meßleitungen ist nicht nur äußerst störend, sondern stellt auch eine erhebliche Gefahrenquelle sowohl für den Benutzer wie auch die zu prüfenden Apparaturen dar. Um solche Gefahren zu vermeiden müßten die Meßleitungen aus dem Meßgerät entfernt und in der Hand getragen werden, wodurch diese jedoch wieder für andere Arbeiten blockiert wäre.

Weiterhin wird in der DE-A-28 43 221 ein elektrisches Prüfgerät beschrieben, bei dem das Meßgerät mit einer ersten Meßspitze vereinigt und mit einer zweiten Meßspitze über ein Spiralkabel elektrisch verbunden ist. Sobald man die Hände für andere Arbeiten frei haben muß, wird man dieses Prüfgerät auf einem Tisch ablegen, wobei das Spiralkabel viel Platz beansprucht und an anderen Gegenständen hängenbleiben kann. Von dieser Vorveröffentlichung geht Anspruch 3 der Erfindung in seinem Oberbegriff aus.

Aufgabe der Erfindung ist es, eine tragbare Meßvorrichtung zu schaffen, die für Meß- und Prüfarbeiten vor Ort um den Hals gehängt werden kann, bei der die Meßspitzen gut greifbar angeordnet sind, die Länge der Meßleitungen ausreicht und aus der Hand gelegte nicht benötigte Meßspitzen keine unkontrollierten Bewegungen ausführen.

Diese Aufgabe wird durch die in den unabhängigen Ansprüchen 1 und 3 gekennzeichneten Merkmale gelöst. Vorteilhafte Ausgestaltungen und Weiterbildungen der Erfindung sind in den Unteransprüchen gekennzeichnet.

Ein wesentlicher Vorteil der erfindungsgemäßen Meßvorrichtung ist, daß die Meßleitungen nicht vom Vielfachmeßgerät herabhängen, sondern ausgehend von diesem über den Traggurt nach oben geführt werden und oberhalb des Meßgerätes austreten und herabhängen. Um mit einem ausreichenden Aktionsradius messen zu können, müssen die Meßleitungen entsprechend lang sein. Da die Meßleitung zwischen Traggurt und Meßspitze als dehnbares Spiralkabel gestaltet ist, hängt sie nur etwa bis zum Vielfachmeßgerät herab kann aber bei der Messung erheblich gestreckt werden. Unkontrollierbare Pendelbewegungen werden dadurch schon erheblich geringer, durch Benutzung der erfindungsgemäßen Halterung kann man sie jedoch völlig vermeiden.

In Weiterbildung der in Anspruch 1 gekennzeichneten ersten Lösung ist die Meßvorrichtung so aufgebaut, daß das Meßgerät zwischen den beiden Enden des Traggurtes befestigt ist. Im Bereich dieser beiden Enden sind auch die vom Traggurt geführten Meßleitungen mit dem Meßgerät elektrisch verbunden.

Die modernen integrierten Bauelemente erlauben es, sehr kleine Meßgeräte zu entwickeln, so daß es möglich ist, das Meßgerät mit einer der beiden Meßspitzen zu vereinigen. Nach der im Anspruch 3 gekennzeichneten zweiten Lösung ist das Meßgerät in diesem Fall nicht mehr zwischen den beiden Enden des Traggurtes, sondern nur noch an einem Ende der als Spiralkabel ausgeführten Meßleitung befestigt. Die Meßleitung wird wiederum durch den Traggurt geführt, jedoch nunmehr durchgehend bis zur anderen Meßspitze. Es ist vorteilhaft, im Bereich der freien Enden des Traggurtes einen Verbindungssteg einzufügen, um ein Abgleiten des Traggurtes von der Schulter zu vermeiden.

Von erheblicher Bedeutung für den Bedienungskomfort der Meßvorrichtung ist, daß die Meßspitzen leicht greifbar sind und nicht unkontrolliert umherpendeln. Ein bequemes Einstecken der Meßspitzen wird dadurch erzielt, daß die Halterung als Haltetaschen ausgebildet und im Bereich der Enden des Traggurtes befestigt sind. Eine schnelle Halterung der Meßspitzen ist auch durch einen am Traggurt befestigten Haltedorn möglich, der in eine Halteöffnung der Meßspitzen eingreift. Hier wird im Prinzip eine Druckknopftechnik verwendet, die mit der Haltetasche zusammenwirken kann, aber auch ohne diese auskommt.

Es ist vorteilhaft, wenn die Meßleitungen etwa in Schulterhöhe aus dem Traggurt austreten, da sie hierdurch eine ausreichende Länge bekommen, die Meßspitzen jedoch nur so tief hängen, daß sie mit der Hand leicht erreichbar sind. Der Traggurt ist in der Mitte, also in einem Bereich in dem keine Meßleitungen geführt sind, teilbar. Hierdurch kann der Aktionsradius der Meßleitungen um die Länge des Traggurtes erhöht werden, sobald mit der Meßvorrichtung auf einem Tisch gearbeitet werden soll.

Die Meßleitung ist dort, wo sie aus dem Traggurt austritt, sehr bruchgefährdet. Um eine Beschädigung der Meßleitung zu vermeiden, ist deshalb an diesen Stellen ein Bruchschutzelement am Traggurt befestigt.

Weitere Einzelheiten und Vorteile des Erfindungsgegenstandes werden nachstehend anhand von Beispielen erläutert.

Es zeigen :

Figur 1 eine Meßvorrichtung, bei der das Meßgerät zwischen den Enden eines Traggurtes aufgehängt ist,

Figur 2 eine der Fig. 1 entsprechende Meßvorrichtung, bei der der Traggurt in der Mitte geteilt ist,

Figur 3 eine Meßvorrichtung, bei der das Meßgerät mit einer Meßspitze vereinigt ist,

Figur 4 eine Variante der Fig. 3, bei der die Meßspitzen nur über einen Haltedorn mit dem Traggurt verbunden sind und

Figur 5 eine weitere Variante der Fig. 3, bei der die Meßspitzen in eine Bereitschaftstasche einsteckbar sind.

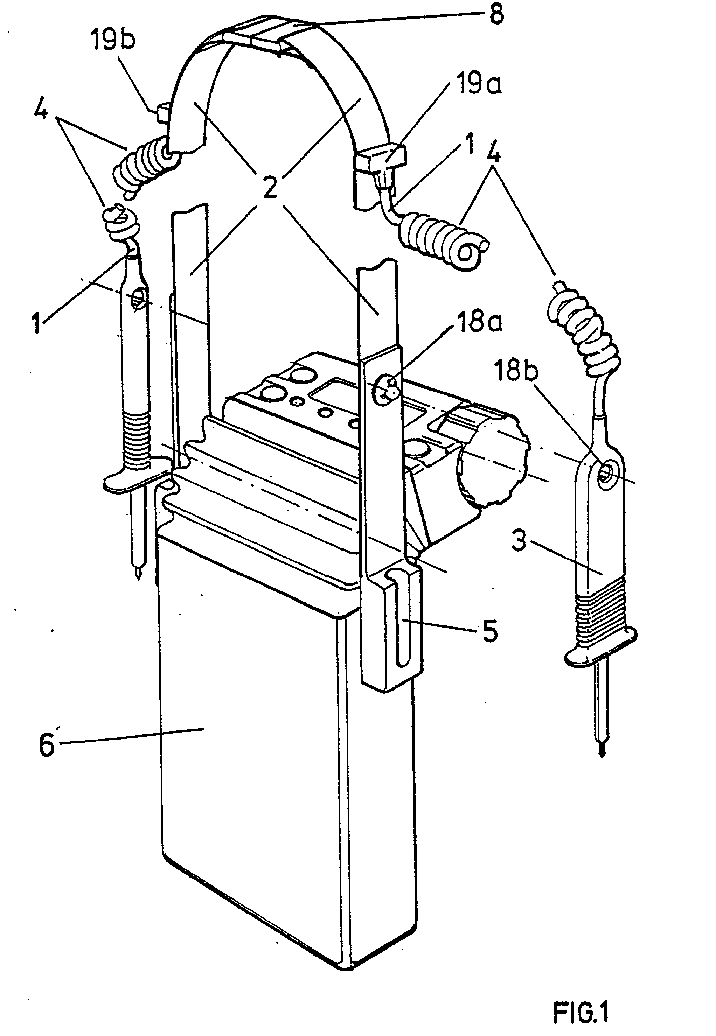

Wie Fig. 1 erkennen läßt, besteht die Meßvorrichtung aus einem Meßgerät 6, einem Traggurt 2, Meßleitungen 1 und Meßspitzen 3. Der Traggurt 2 ist beidseitig des Meßgerätes 6 befestigt und besitzt an seinen Enden Halterungen 5, 18, die zum Halten der Meßspitzen 3 dienen. Die Halterung besteht aus Haltetaschen 5 und/oder Druckknopfverbindungen 18. Bei der Druckknopfverbindung 18 greift ein Haltedorn 18a in eine Halteöffnung 18b, die im Griffbereich der Meßspitze 3 ausgebildet ist.

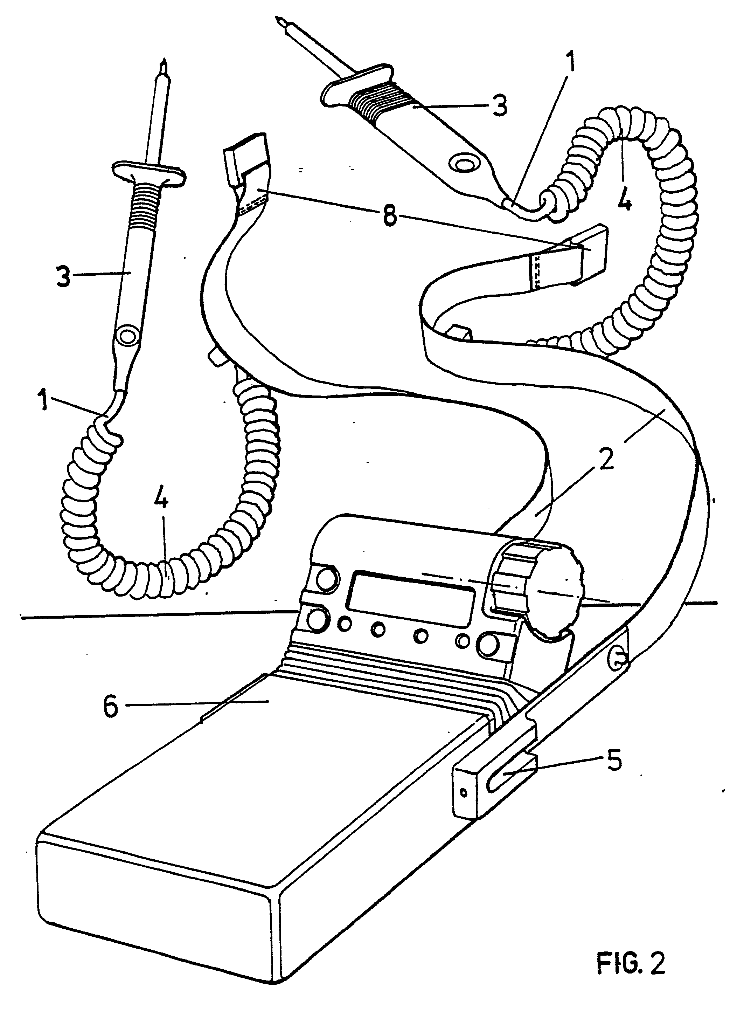

Die Meßleitungen 1 sind, in der Darstellung nicht erkennbar, im Bereich der Befestigungsstellen des Haltegurtes 2 mit dem Meßgerät 6 elektrisch verbunden. Innerhalb des Traggurtes 2 verlaufen dann die Meßleitungen 1, ebenfalls nicht sichtbar dargestellt, bis etwa in Schulterhöhe des Benutzers und treten über Bruchschutzelemente 19 aus dem Haltegurt aus. Zwischen den Bruchschutzelementen 19 und den Meßspitzen 3 sind die Meßleitungen als dehnbare Spiralkabel 4 ausgebildet. Dadurch läßt sich der Aktionsradius der Meßspitzen 3 nahezu beliebig variieren. Um auch die Länge der im Traggurt 2 verlaufenden Meßleitungen 1 voll nutzen zu können, kann der Traggurt in der Mitte geteilt werden. Hierzu dient eine Verbindungsvorrichtung 8, die allerdings nur bei Arbeiten auf einem Tisch geöffnet werden kann. Fig. 2 zeigt die Meßvorrichtung auf einem Tisch bei geöffnetem Traggurt.

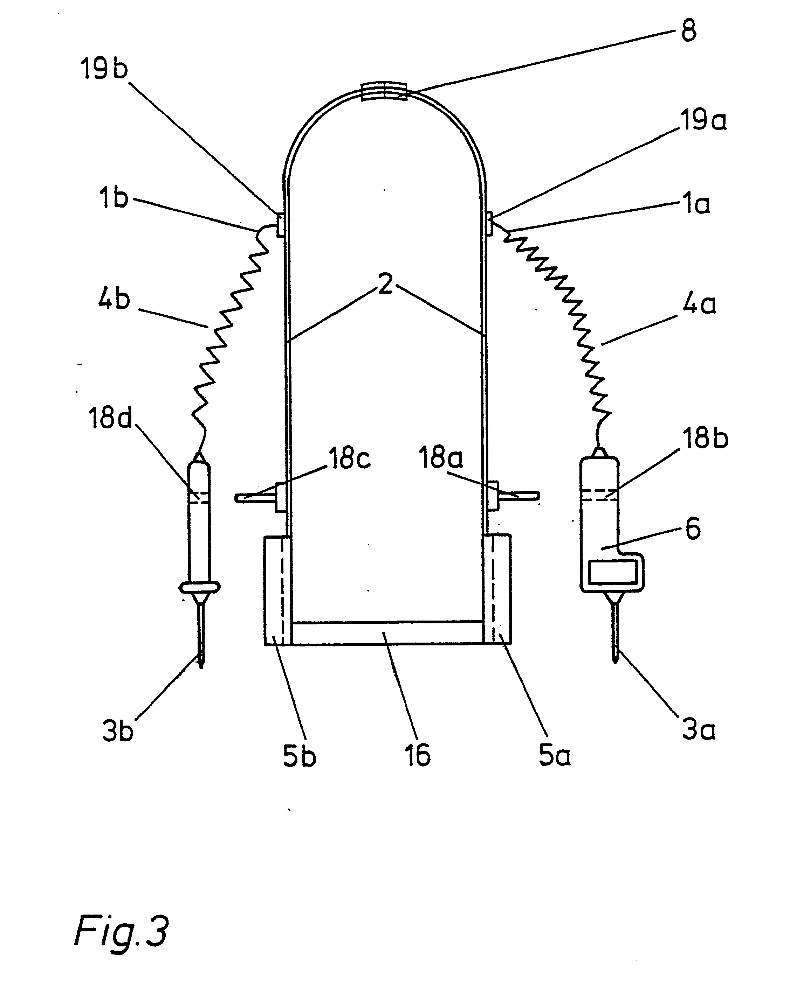

In Fig. 3 ist eine Meßvorrichtung dargestellt, bei der ein Meßgerät 6 mit einer Meßspitze 3a vereinigt ist. Der Traggurt ist ähnlich aufgebaut wie bei den Meßvorrichtungen der Figuren 1 und 2. Für die Meßspitzen 3a, 3b sind Haltetaschen 5a, 5b am Traggurt 2 vorgesehen. Ein Unterschied besteht jedoch in der Führung der Meßleitungen 1, die über den Traggurt 2 durchgehend verbunden sein müssen. Je nach Leitungsführung muß entweder das Verbindungselement 8, das zum Trennen des Traggurtes dient, entfallen bzw. mit Kontakten versehen werden oder die Meßleitung muß über einen Verbindungssteg 16 geführt werden. Der Verbindungssteg 16 hat zudem den Vorteil, daß er den Traggurt 2 daran hindert, von der Schulter zu gleiten.

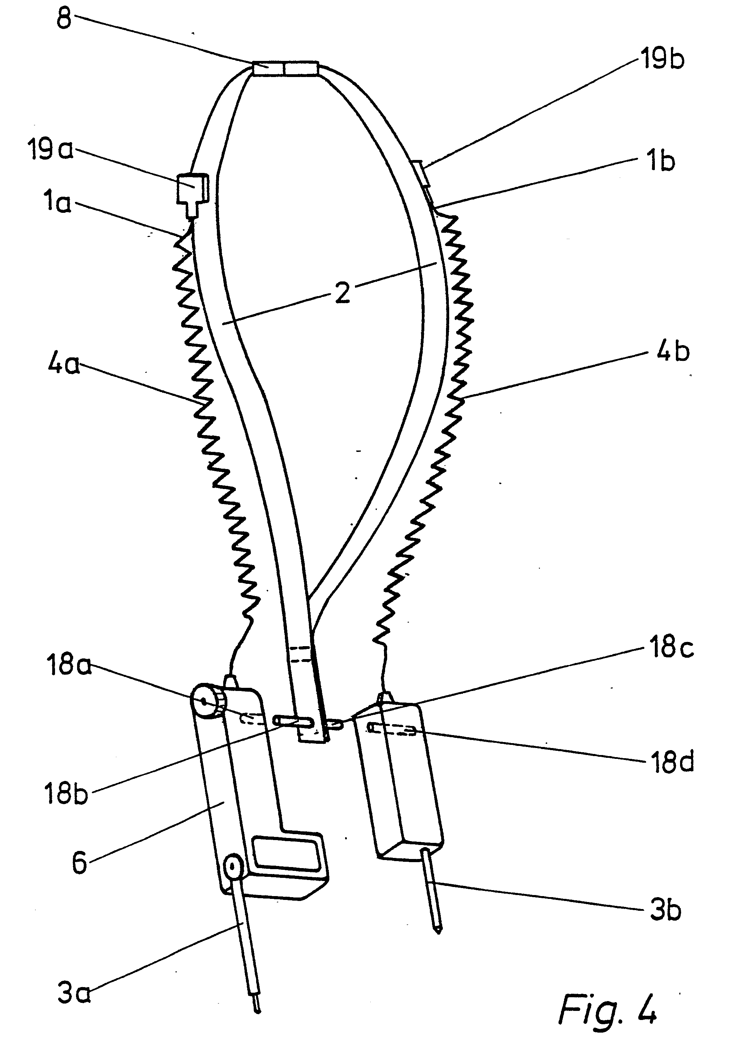

Die in Fig. 4 dargestellte tragbare Meßvorrichtung entspricht weitgehend der Fig. 3. Hierbei wird jedoch auf eine Haltetasche verzichtet. Ein am Traggurt befestigter Haltedorn 18b, c wird in zwei Öffnungen 18a, d der Meßspitzen 3a, b eingesteckt. Da die beiden Meßspitzen in ihrer Form so aufeinander abgestimmt sind, daß die eine Meßspitze 3b in einer Aussparung der anderen Meßspitze 3a bzw. des Meßgerätes 3 platzfindet, ergibt sich eine sichere und bequeme Befestigung am Traggurt 2.

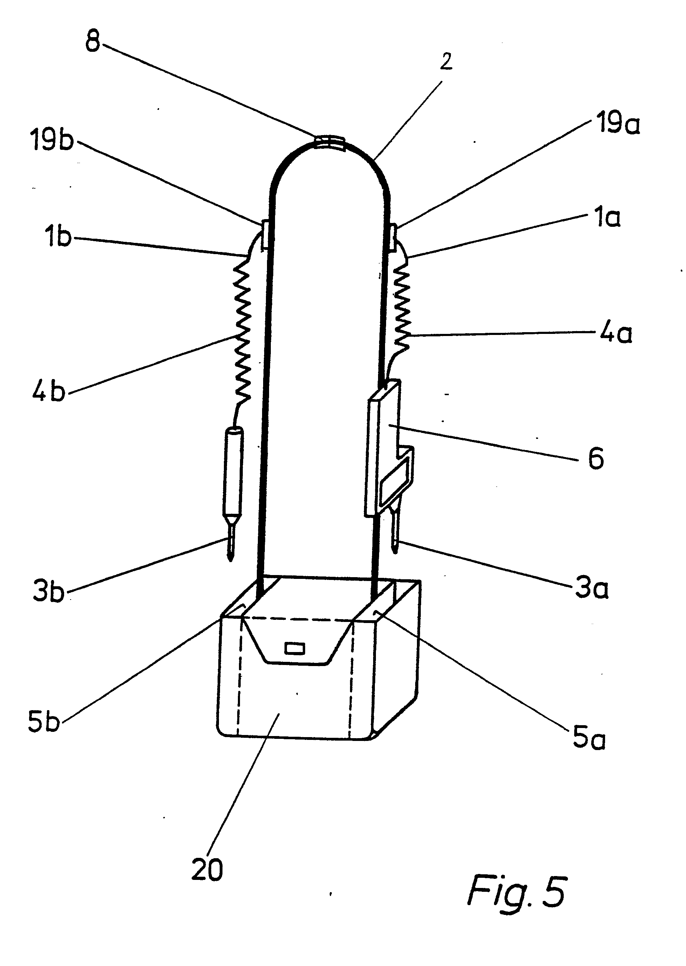

In Fig. 5 ist eine Meßvorrichtung dargestellt, bei der eine Bereitschaftstasche 20 zwischen den beiden Enden des Traggurtes 2 befestigt ist. Diese Bereitschaftstasche ist mit seitlichen Fächern für die Meßspitzen 3 und einem Mittelfach für Meßzubehör ausgestattet.

**Patentansprüche**

1. Tragbare Meßvorrichtung mit einem um den Hals zu hängenden Traggurt (2), an dem das zu tragende Meßgerät (6) befestigt ist, und Meßleitungen (1), die das Meßgerät (6) elektrisch mit Meßspitzen (3) verbinden, dadurch gekennzeichnet, daß die Meßleitungen (1) teilweise über den Traggurt (2) oder einen Teilbereich des Traggurtes (2) geführt sind und der zwischen dem Traggurt (2) und einer Meßspitze (3) liegende Teil einer Meßleitung (1) als dehnbares Spiralkabel (4) gestaltet ist und an der Meßvorrichtung mindestens eine Halterung (5, 18) vorgesehen ist, die zur Befestigung der an den Meßleitungen (1, 4) hängenden Meßspitzen (3) dient, wenn diese nicht benutzt werden.

2. Tragbare Meßvorrichtung nach Anspruch 1, dadurch gekennzeichnet, daß das Meßgerät (6) zwischen den beiden Enden des Traggurtes (2) befestigt ist und im Bereich dieser beiden Enden die vom Traggurt (2) geführten Meßleitungen (1) mit dem Meßgerät (6) elektrisch verbunden sind.

3. Tragbare Meßvorrichtung, bei der ein Meßgerät (6) mit einer ersten Meßspitze (3a) konstruktiv vereinigt und eine zweite Meßspitze (3b) über eine zumindest teilweise als Spiralkabel (4) gestaltete Meßleitung (1) elektrisch verbunden ist, dadurch gekennzeichnet, daß ein um den Hals zu hängender Traggurt (2) vorgesehen ist, an dem sich eine Halterung (5a, 5b, 18a, 18c) befindet, die zur Befestigung der beiden an ihrer Meßleitung (1, 4) hängenden Meßspitzen dient, wenn diese nicht benutzt werden und die Meßleitung (1, 4) teilweise über den Traggurt (2) oder einen Teilbereich des Traggurtes (2) geführt ist, wobei der spiralkabelartige Teil (4) der Meßleitung (1, 4) jeweils zwischen dem Traggurt (2) und der Meßspitze (3a, 3b) liegt.

4. Tragbare Meßvorrichtung nach Anspruch 3, dadurch gekennzeichnet, daß im Bereich der Enden des Traggurtes (2) ein Verbindungssteg (16) eingefügt ist oder die Enden unmittelbar miteinander verbunden sind.

5. Tragbare Meßvorrichtung nach Anspruch 3, dadurch gekennzeichnet, daß zwischen den beiden Enden des Traggurtes (2) eine Bereitschaftstasche (20) befestigt ist, in welche die Meßspitzen (3a, 3b) einsteckbar sind.

6. Tragbare Meßvorrichtung nach einem der vorhergehenden Ansprüche, dadurch gekennzeichnet, daß die zum Halten der Meßspitzen (3) dienenden Halterungen (5, 18) als Haltetaschen ausgebildet und im Bereich der Enden des Traggurtes (2) befestigt sind.

7. Tragbare Meßvorrichtung nach einem der Ansprüche 1 bis 5, dadurch gekennzeichnet, daß in Verbindung mit einer Haltetasche (5) oder ohne eine solche zum Befestigen der Meßspitzen (3) am Traggurt (2) ein Haltedorn (18a, 18c) befestigt ist, der in eine Halteöffnung (18b, 18d) der Meßspitze (3) eingreift.

8. Tragbare Meßvorrichtung nach einem der vorhergehenden Ansprüche, dadurch gekennzeichnet, daß die Meßleitungen (1) etwa in Schulterhöhe des Benutzers aus dem Traggurt (2) austreten und beidseitig herabhängend zu je einer Meßspitze (3) führen und an der Stelle, an der die Meßleitung (1) aus dem Traggurt (2) austritt und in das Spiralkabel (4) übergeht, ein Bruchschutzelement (19) am Traggurt (2) befestigt ist.

9. Tragbare Meßvorrichtung nach einem der vorhergehenden Ansprüche, dadurch gekennzeichnet, daß der Traggurt (2) in der Mitte durch eine Verbindungsvorrichtung (8) teilbar und wieder zusammenfügbar ist.

10. Tragbare Meßvorrichtung nach einem der Ansprüche 3, 4 oder 7 bis 9, sofern letztere sich auf Anspruch 3 beziehen, dadurch gekennzeichnet, daß das mit der Meßspitze (3a) vereinigte Meßgerät (6) so gestaltet ist, daß es eine Aussparung aufweist, die zur Aufnahme der anderen Meßspitze (3b) geeignet ist und damit eine zweckmäßige Verbindung beider ermöglicht und eine Haltedornbefestigung (18) sie in Gurthöhe hält.

**Claims**

1. Portable measuring device with a carrying strap (2) which is to be hung round the neck and to which the measuring instrument (6) to be carried is fastened, and with measuring leads (1) which connect the measuring instrument (6) electrically to test prods (3), characterized in that the measuring leads (1) are guided partially *via* the carrying strap (2) or a part region of the carrying strap (2), and the portion of a measuring lead (1) located between the carrying strap (2) and a test prod (3) is designed as an extendable spiral cable (4), there being on the measuring device at least one mounting (5, 18) which serves for fastening the test prods (3) hanging on the measuring leads (1, 4), when these test prods (3) are not in use.

2. Portable measuring device according to claim 1, characterized in that the measuring instrument (6) is fastened between the two ends of the carrying strap (2), and in the region of these two ends the measuring leads (1) guided by the carrying strap (2) are connected electrically to the measuring instrument (6).

3. Portable measuring device, in which a measuring instrument (6) is combined constructively with a first test prod (3a) and a second test prod (3b) is connected electrically *via* a measuring lead (1) designed at least partially as a spiral cable (4), characterized in that there is a carrying strap (2) which is to be hung round the neck and on which is located a mounting (5a, 5b, 18a, 18c) which serves for fastening the two test prods hanging on their measuring lead (1, 4) when these test prods are not in use, and the measuring lead (1, 4) is guided partially *via* the carrying strap (2) or a part region of the carrying strap (2), the part (4) of the measuring lead (1, 4) resembling a spiral cable being located respectively between the carrying strap (2) and the test prod (3a, 3b).

4. Portable measuring device according to claim 3, characterized in that a connecting web (16) is inserted in the region of the ends of the carrying strap (2), or the ends are connected directly to one another.

5. Portable measuring device according to claim 3, characterized in that fastened between the two ends of the carrying strap (2) is an everready pouch (20), into which the test prods (3a, 3b) can be inserted.

6. Portable measuring device according to one of the preceding claims, characterized in that the mountings (5, 18) serving for holding the test prods (3) are designed as holding pouches and are fastened in the region of the ends of the carrying strap (2).

7. Portable measuring device according to one of claims 1 to 5, characterized in that, in conjunction with or without a holding pouch (5), to fasten the test prods (3) a holding peg (18a, 18c) is fastened to the carrying strap (2) and engages into a holding orifice (18b, 18d) in the test prod (3).

8. Portable measuring device according to one of the preceding claims, characterized in that the measuring leads (1) project from the carrying strap (2) approximately at the user's shoulder height and, hanging down on both sides, each lead to a test prod (3), and at the point where the measuring lead (1) projects from the carrying strap (2) and merges into the spiral cable (4) a breakage prevention element (19) is fastened to the carrying strap (2).

9. Portable measuring device according to one of the preceding claims, characterized in that the carrying strap (2) can be separated and joined together again in the middle by means of a connecting device (8).

10. Portable measuring device according to one of claims 3 and 4 or 7 to 9, insofar as the latter refer to claim 3, characterized in that the measuring instrument (6) combined with the test prod (3a) is designed so that it has a recess which is suitable for receiving the other test prod (3b) and which consequently allows the two to be connected in an expedient way, and a holding-peg fastening (18) holds them at strap height.

## Revendications

1. Dispositif de mesure portatif comprenant une bretelle (2) à passer autour du cou et à laquelle est fixé l'appareil de mesure (6) à porter, et des fils électriques (1) qui relient l'appareil de mesure (6) aux fiches de contrôle (3), caractérisé par le fait que les fils (1) sont en partie logés dans la bretelle (2) ou une zone partielle de la bretelle (2), que la partie d'un fil (1) compris entre la bretelle (2) et une fiche de contrôle (3) est réalisée sous la forme d'un câble torsadé extensible (4) et que sur le dispositif de mesure est prévu au moins un support (5, 18) qui sert à la fixation des fiches de contrôle (3) suspendues aux fils (1, 4) lorsqu'elles ne sont pas utilisées.

2. Dispositif de mesure portatif selon la revendication 1, caractérisé par le fait que l'appareil de mesure (6) est fixé entre les deux extrémités de la bretelle (2) et que les fils électriques (1) logés dans la bretelle (2) sont raccordés à l'appareil de mesure (6) dans la zone de ces deux extrémités.

3. Dispositif de mesure portatif dans lequel un appareil de mesure (6) fait corps avec une première fiche de contrôle (3a) et une seconde fiche de contrôle (3b) est raccordée par un fil électrique (1) au moins en partie réalisé sous la forme d'un câble torsadé (4), caractérisé par le fait qu'il est prévu une bretelle (2) à passer autour du cou et sur laquelle se trouve un support (5a, 5b, 18a, 18c) qui sert à la fixation des deux fiches de contrôle suspendues à leurs fils (1, 4) lorsque celles-ci ne sont pas utilisées et que le fil électrique (1, 4) est en partie logé dans la bretelle (2) ou une zone partielle de la bretelle (2), la partie (4) en forme de câble torsadé du fil électrique (1, 4) étant respectivement située entre la bretelle (2) et la fiche de contrôle (3a, 3b).

4. Dispositif de mesure portatif selon la revendication 3, caractérisé par le fait qu'une entretoise (16) est insérée dans la zone des extrémités de la bretelle (2) ou que les extrémités sont mutuellement directement raccordées.

5. Dispositif de mesure portatif selon la revendication 3, caractérisé par le fait qu'entre les deux extrémités de la bretelle (2) est fixée une poche (20) dans laquelle les fiches de contrôle (3a, 3b) peuvent être placées prêtes à l'emploi immédiat.

6. Dispositif de mesure selon l'une des revendications précédentes, caractérisé par le fait que les supports (5, 18) servant au rangement des fiches de contrôle (3) sont réalisés en forme de poches et fixés dans la zone des extrémités de la bretelle (2).

7. Dispositif de mesure portatif selon l'une des revendications 1 à 5, caractérisé par le fait qu'en combinaison avec une telle poche de rangement (5) ou sans une telle poche pour le rangement des fiches de contrôle (3), une broche de retenue (18a, 18c) est fixée sur la bretelle (2) et s'engage dans un perçage (18b, 18d) de la fiche de contrôle (3).

8. Dispositif de mesure portatif selon l'une des revendications précédentes, caractérisé par le fait que les fils électriques (1) sortent de la bretelle (2) à peu près à la hauteur de l'épaule de l'utilisateur et descendent chacun en pendant des deux côtés jusqu'à une fiche de contrôle (3) et qu'un élément antirupture (19) est fixé sur la bretelle (2) à l'endroit où le fil électrique (1) sort de la bretelle (2) et se transforme en câble torsadé (4).

9. Dispositif de mesure portatif selon l'une des revendications précédentes, caractérisé par le fait que la bretelle (2) peut être séparée en deux en son milieu et à nouveau réunie au moyen d'un dispositif de raccordement (8).

10. Dispositif de mesure portatif selon l'une des revendications 3, 4 ou 7 à 9 dans la mesure où ces dernières se rapportent à la revendication 3, caractérisé par le fait que l'appareil de mesure (6) faisant corps avec la fiche de contrôle (3a) est façonné de manière à présenter un évidement pouvant recevoir l'autre fiche de contrôle (3b) et permettre ainsi un assemblage avantageux des deux fiches et qu'une fixation à broche (18) maintient celles-ci à la hauteur de la bretelle.

FIG.1

FIG. 2

Fig.3

0 100 950

Fig. 4

*Fig. 5*